# EUROPEAN PATENT APPLICATION

(11) **EP 3 958 661 A2**
(43) Date of publication of application: **23.02.2022**
(21) Application number: 21187180.1
(22) Date of filing: 22.07.2021
(51) Int. Cl.: H05K 7/20

(54) **ELECTRONIC ASSEMBLY**

(30) Priority: 19.08.2020 IN 202041035803
(71) Applicant: TVS Motor Company Limited, 600006 Chennai (IN)
(72) Inventor: Godwin, George, 600006 Chennai (IN); Senthilnathan, Subbiah, 600006 Chennai (IN); Samraj, Jabez Dhinagar, 600006 Chennai (IN)
(74) Representative: Patentanwaltskanzlei Matschnig & Forsthuber OG

(57) **Abstract**

An electronic assembly (102) of an electronic product (100) is disclosed comprising a base member (201), a plurality of electronic components (204) removably positioned in a predetermined sequence on the base member (201), and a heat dissipation assembly (212) positioned in thermal contact with each of the plurality of electronic components (204) on the base member (201). The electronic components are rows of transistors (301, 302, 304, 305, 307, 308) positioned across a top surface (201b) of the base member (201) and rows of capacitors (303, 306) sequentially spaced from the rows of transistors (301, 302, 304, 305, 307, 308). Such positioning of the electronic components (204) ensures compact packaging of the electronic product (100) and the thermal management of the electronic components (204) for efficient and long use of the electronic product (100).

## Description

### TECHNICAL FIELD

The present subject matter relates to an electronic assembly. More particularly and not exclusively, it pertains to heat dissipation in the electronic assembly.

### BACKGROUND

In recent years, processor based systems and computer systems have found widespread application in any engineering domain. The processor based systems are temperature sensitive and perform their intended function only when the temperature of the system is within the optimal operating range. To maintain acceptable operating temperatures, the processor based systems utilize a variety of thermal management devices. In the case of automotive industry, electric power train in electric vehicles and hybrid electric vehicles also require heat dissipation and thermal management for its efficient functioning.

### BRIEF DESCRIPTION OF DRAWINGS

The detailed description is described with reference to the accompanying figures. The same numbers are used throughout the drawings to reference like features and components.
Fig. 1 exemplarily illustrates an exploded perspective view of an electronic product;
Fig. 2 exemplarily illustrates a perspective view of the electronic assembly, exemplarily illustrated in Fig. 1;
Fig. 3 exemplarily illustrates a perspective view of the electronic components positioned on the base member of the electronic assembly;
Fig. 4 exemplarily illustrates a partial exploded perspective view of the electronic assembly shown in Fig. 2;
Fig. 5 exemplarily a sectional perspective view of the electronic assembly exemplarily illustrated in Fig. 4;
Fig. 6A exemplarily illustrates a partial sectional perspective view of a transistor bridge of the electronic assembly;
Fig. 6B exemplarily illustrates an exploded perspective view of the transistor bridge of the electronic assembly;
Fig. 7 exemplarily illustrates a partial exploded perspective view of a capacitor bridge of the electronic assembly; and
Fig. 8 exemplarily illustrates a partial exploded perspective view of a voltage converter bridge of the electronic assembly.

### DETAILED DESCRIPTION OF THE INVENTION

In electric/ hybrid electric vehicles, the parts of the electric drive train, such as, one or more controllers, one or more inverters, power boards, voltage converter boards, etc., tend to get heated up and may fail to function after a certain number of use cycles causing discomfort to the rider of the vehicle, during normal usage and/or prolonged operation. Sometimes, the continuous heating up may also lead to fire propagation in the electric drive train, leading to a catastrophic failure of the electric drive train and the vehicle. Thus, there is a need to effectively dissipate the generated heat in the parts and efficiently cool the parts for good performance and longevity as well as to arrest propagation of fire, if any, for the safety of a product employing the components, such as, the vehicle.

Based on the output wattage of the electric or hybrid electric vehicle, the number, size, and technical specifications, of the parts in the vehicle, vary. Each of these parts has multiple electrical and electronic components, such as, capacitors, transistors, resistors, etc., whose specifications and ratings also vary. For a higher wattage of the electric drive train of the vehicle, the electrical and electronic components vary in quantity, in size, in ratings, and other technical specifications. With the increased sizes and numbers, the positioning of the electrical and electronic components in the various parts of the electrical drive train is difficult and needs to be performed optimally.

The electrical and electronics components, such as, the ICs, transistors, capacitors, resistors, etc., are usually mounted and soldered to a PCB board. The mounting of these components on the PCB board should not make it clumsy, congested and difficult for troubleshooting, maintenance, and replacement. However, if the components are distantly spaced for easy maintenance, accessibility during servicing and maintenance; then the subsystems of electric drive train become large in size and difficult to be accommodated in a compact space which is typically limited in a vehicle. Thus, there is a need to optimally assemble the electrical and electronic components in the parts of the electric drive train so as to enable access to troubleshoot, service, maintain, and replace, while not making the assembly undesirably bulky, clumsy, large in size, etc.

Also, with the increased rated specifications of the electrical and electronic components, such as, maximum voltage specification, frequency band of operation, etc., in high wattage vehicles, the heat dissipation from the electrical and electronic components also increases. If in case the components are located very proximal to each other, apart from inaccessibility, there are high chances of propagation of the generated heat from one component to another, leading to grave increase in the temperature of the PCB board. The components may fail to function beyond a rated temperature, the electrical connections on the PCB board may fail, and the PCB board may get structurally deformed, etc., at higher temperatures. The components may ignite and cause a fire and the fire may propagate, leading to a catastrophic failure of the electric drive train as well as the vehicle employing it. Overall, there exists a problem of potential safety risk to the vehicle and its user.

As per known art, the electronic assemblies of the electronic products or vehicle parts, such, inverters, converters, power board, controller, etc., in the electric drive train are provided with a sacrificial member that melts down and creates a space between the electrical and electronic components to arrest propagation of fire. However, probability of the sacrificial member being non-functional at the time of need makes this mechanism not effective. Despite employing the sacrificial member, there still exists a need for extracting heat from the individual components to reduce the probability of drastic increase in the temperatures of the components and the PCB board in a failsafe manner.

In an implementation for cooling of the electronic assembly, and in turn the components constituting the electronic assembly, a heat exchange member is in thermal contact with the casing of the electronic product and forced convection is employed. The heat dissipated from the electrical and electronic components on the PCB has to traverse through air-filled gap between the components and the casing. The heat transfer between the components and the casing may not be efficient since air is a poor conductor of heat. In order to ensure that heat is effectively dissipated from the components, it is essential to ensure that the heat generating components are reliably secured to be in thermal contact with the heat exchange member proximal to the casing. Another existing implementation employs liquid cooling for thermal management in the electronic product or the electronic assembly of the electronic product. The electronic product or the electronic assembly as a whole may be immersed into a liquid coolant. However, the liquid coolant is stagnant and efficiency of cooling of the electronic assembly is substantially less. In case of forced liquid flow for cooling individual electrical and electronic components, the electronic product becomes more complex, undesirably larger to package and also adds to the cost. Also there exists a challenge of enabling the coolant to reach all the hot zones while maintaining a compact layout. There is exists a need for an active cooling system that dissipates the heat from each of the electrical and electronic components of the electronic assembly, yet not making the electronic assembly undesirably bulky.

Therefore, there exists a need for an improved design of an electronic product and electronic assembly in the electronic product that is light in weight, optimal in size, with efficient and effective heat transfer from the electrical and electronic components which additionally provides ease and safety during assembly, use, maintenance, and servicing of the electronic assembly, while curtailing fire propagation and overcoming all problems disclosed above as well as other problems of known art.

In an embodiment, an electronic assembly with a layout of electronic components is disclosed as the present invention. The electronic assembly is enclosed in a casing to form an electronic product. The electronic assembly comprises a base member, a plurality of electronic components removably positioned in a predetermined sequence on the base member; and a heat dissipation assembly positioned in thermal contact with each of the plurality of electronic components on the base member.

The plurality of electronic components positioned in a predetermined sequence comprises a plurality of rows. A plurality of capacitors, and at least one voltage converter board. The plurality of rows of transistors are positioned across a top surface of the base member longitudinally. Each of the plurality of rows of transistors comprises a plurality of transistors positioned consecutively in a lateral direction of the base member. The plurality of rows of capacitors are sequentially spaced from the plurality of rows of transistors on the top surface of the base member. Each of the plurality of rows of capacitors comprises a plurality of capacitors positioned consecutively in a lateral direction of the base member. The at least one voltage converter board is positioned on the top surface of the base member proximal to an edge of the base member.

The heat dissipation assembly comprises a plurality of cooling rails, a plurality of transistor bridges, a plurality of capacitor bridges, and at least one voltage converter bridge. The plurality of cooling rails are positioned proximal to sides of the base member and extending longitudinally for facilitating flow of coolant longitudinally across the base member. The plurality of transistor bridges extending between the plurality of cooling rails and in thermal contact with the plurality of rows of transistors for dissipating the heat from the plurality of rows of transistors. The plurality of capacitor bridges extend between the plurality of cooling rails and are in thermal contact with the plurality of rows of capacitors for dissipating the heat from the plurality of rows of capacitors. The at least one voltage converter bridge extends between the plurality of cooling rails and is in thermal contact with the at least one voltage converter board for dissipating the heat from the at least one voltage converter board.

The plurality of cooling rails comprise an inlet nozzle, an outlet nozzle, and end caps. The inlet nozzle removably engages with one end of one of the plurality of cooling rails for the coolant to flow into the plurality of cooling rails to extract heat from the plurality of rows of transistors, the plurality of rows of capacitors, and the at least one voltage converter board. The outlet nozzle removably engages with one end of another cooling rail of the plurality of cooling rails for the coolant to flow out, after extracting heat, from the plurality of rows of transistors, the plurality of rows of capacitors, and the at least one voltage converter board using the plurality of transistor bridges, the plurality of capacitor bridges, and the at least one voltage converter bridge.

Each of the plurality of transistor bridges comprises an inlet port, an outlet port, a depression, and a cover. The inlet port is removably connected to the one of the plurality of cooling rails for the coolant to flow in. The outlet port is removably connected to another cooling rail of the plurality of cooling rails for the coolant to flow out after extracting heat from the plurality of transistors. The depression extends between a first end of the inlet port and a first end of the outlet port and is configured to be filled with the coolant for extracting heat from the plurality of transistors and the cover removably attached to peripheral walls of the depression for closing the depression.

In an embodiment, each of the plurality of transistor bridges further comprises a plurality of heat transfer members disposed in the depression and extending from the bottom surface of the depression along the length of the peripheral walls of the depression, for heat transfer from each of the plurality of transistors to the coolant in the depression. In an embodiment, the cover of each of the plurality of transistor bridges comprises a plurality of extenders disposed on an inner surface for removably engaging with a plurality of heat transfer members disposed in the depression.

In another embodiment, each of the plurality of transistor bridges comprises a flat first external surface on both sides for establishing thermal contact with the plurality of transistors using an attachment means. In an embodiment, the each of the plurality of transistor bridges comprises a plurality of heat dissipating structures on a second external surface for dissipating the extracted heat from the coolant in the depression to the surroundings.

Each of the plurality of transistor bridges stand erect on the plurality of cooling rails using a second end of the inlet port removably engaging with an opening in the one of the plurality of cooling rails and a second end of the outlet port removably engaging with an opening in another cooling rail of the plurality of cooling rails. The coolant vertically rises in the inlet port through the second end of the inlet port, flows in the depression in a lateral direction of the each of the plurality of transistor bridges, and then exits through the second end of the outlet port.

Each of the plurality of capacitor bridges comprises an inlet port removably connected to the one of the plurality of cooling rails for the coolant to flow in, an outlet port removably connected to another cooling rail of the plurality of cooling rails for the coolant to flow out after extracting heat from the plurality of capacitors, and a housing enclosing the plurality of capacitors positioned on the base member. The housing comprises a bottom portion substantially enclosing the inlet port, the outlet port, and the plurality of capacitors and a top portion extending from a top wall of the bottom portion forming a depression extending between a first end of the inlet port and a first end of the outlet port for the coolant to flow as well as extract heat from the plurality of capacitors. In an embodiment, the housing further comprises a cover removably attached to peripheral walls of the depression for closing the depression.

Each of the plurality of capacitor bridges further comprises a plurality of heat transfer members disposed in the depression and extending from the top wall of the bottom portion along the length of the peripheral walls of the depression, for heat transfer from each of the plurality of capacitors with the coolant in the depression. The contour of the top wall of the bottom portion of the housing conforms with external surface of the plurality of capacitors enclosed by the bottom portion of the housing for establishing thermal contact using an attachment means.

The coolant vertically rises in the inlet port through the second end of the inlet port, flows in the depression in a horizontal direction of the each of the plurality of capacitor bridges, and exits through the second end of the outlet port. The each of the plurality of capacitor bridges stand erect on the plurality of cooling rails using a second end of the inlet port removably engaging with an opening in the one of the plurality of cooling rails and a second end of the outlet port removably engaging with an opening in another cooling rail of the plurality of cooling rails.

The at least one voltage converter bridge comprises an inlet port, an outlet port, s depression, and a cover. The inlet port is removably connected to the one of the plurality of cooling rails for the coolant to flow in. The outlet port is removably connected to another cooling rail of the plurality of cooling rails for the coolant to flow out after extracting heat from the at least one voltage converter board. The depression extending between a first end of the inlet port and a first end of the outlet port is configured to be filled with the coolant for extracting heat from the at least one voltage converter board. The cover is removably attached to peripheral walls of the depression for closing the depression.

In an embodiment, the at least one voltage converter bridge further comprises a plurality of heat transfer members disposed in the depression and extending from the bottom surface of the depression along the length of the peripheral walls of the depression, for heat transfer from each of the plurality of transistors to the coolant in the depression. In another embodiment, the cover of at least one voltage converter bridge comprises a plurality of extenders disposed on an inner surface for removably engaging with a plurality of heat transfer members disposed in the depression.

The at least one voltage converter bridge comprises a flat first external surface on one side for establishing thermal contact with the at least one voltage converter board using an attachment means. The at least one voltage converter bridge stands erect on the plurality of cooling rails using a second end of the inlet port removably engaging with an opening in the one of the plurality of cooling rails and a second end of the outlet port removably engaging with an opening in another cooling rail of the plurality of cooling rails. The coolant vertically rises in the inlet port through the second end of the inlet port, flows in the depression in a lateral direction of the at least one voltage converter bridge, and exits through the second end of the outlet port.

The present subject matter is further described with reference to accompanying figures. It should be noted that the description and figures merely illustrate principles of the present subject matter. Various arrangements may be devised that, although not explicitly described or shown herein, encompass the principles of the present subject matter. Moreover, all statements herein reciting principles, aspects, and examples of the present subject matter, as well as specific examples thereof, are intended to encompass equivalents thereof.

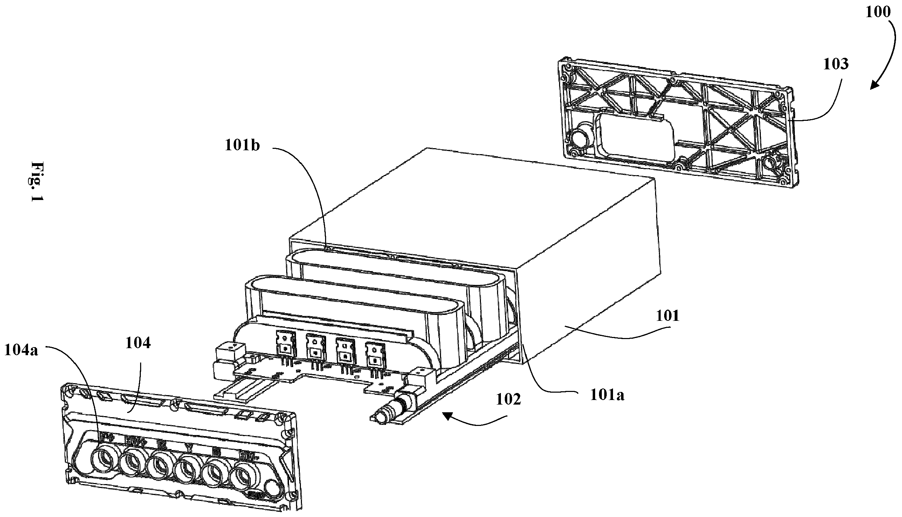

Fig. 1 exemplarily illustrates an exploded perspective view of an electronic product 100. The electronic product 100 may be a part of the drive train of an electric vehicle or a hybrid electric vehicle. The vehicle may be a two-wheeled vehicle, a three wheeled or a multi-wheeled vehicle, such as, a passenger car, a passenger bus, a load carrying truck, etc. The electronic product 100 may be an inverter, a controller, a power conditioning circuit, a voltage converter, etc., of the drive train of the vehicle. The electronic product 100 comprises one or more electronic assemblies, such as, 102. An electronic assembly 102 is a congregation of a multiple electrical and electronic components connected to each other to achieve a defined function, such as, stepping down voltages, converting AC voltage to DC voltage, etc. As exemplarily illustrated, the electronic product 100 comprises a casing 101 enclosing the electrical and electronic components and a pair of end covers 103, 104. The casing 101 is a hollow geometry cover with open ends enclosing the electronic assembly 102. End covers 103, 104 of the electronic product 100 close the open ends, such as, 101a of the casing 101. The casing 101 has mounting provisions 101b to mount the end covers, such as, a first end cover 103 and a second end cover 104 at the open ends 101a, using attachment means. The second end cover 104 has provisions 104a for the external electrical connections of the electronic assembly 100. The first end cover 103 seals the casing 101 on the other side. In an embodiment, an outer surface of the casing 101 may comprise a dovetail pattern that facilitates in easy mounting and removal of the electronic product 100 in a designated space in an application, such as, the vehicle. In an embodiment, an inner surface of the casing 101 may comprise a dovetail pattern that facilitates in easy mounting and removal of the electronic assembly 102 into and out of the casing 101 for accessing the mounted electrical and electronic components.

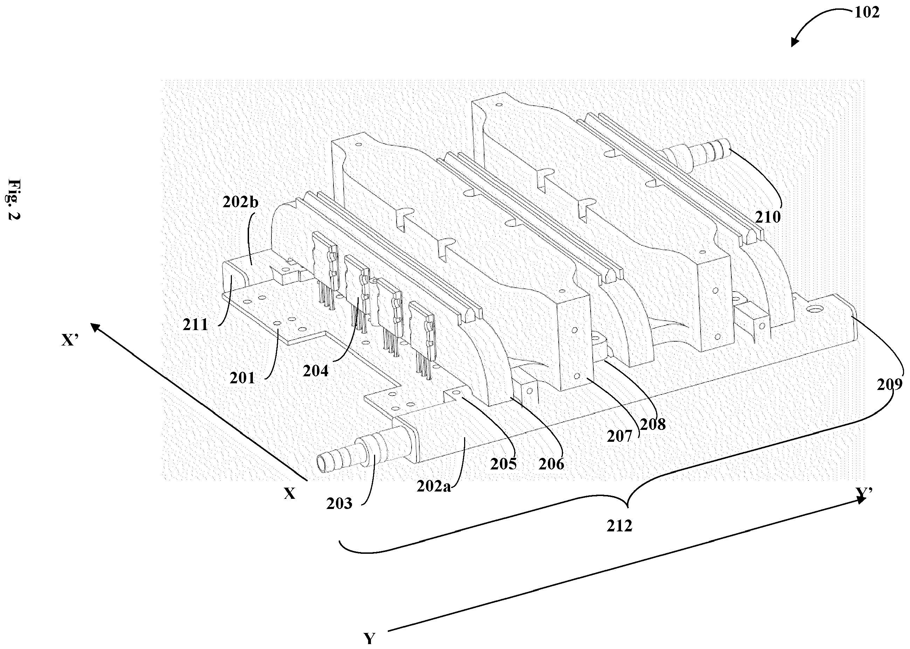

Fig. 2 exemplarily illustrates a perspective view of the electronic assembly 102 exemplarily illustrated in Fig. 1. The electronic assembly 102 comprises a base member 201 for mounting multiple electronic components, such as, 204. In an embodiment, the pins of the electronic components 204 are inserted into openings on the base member 201 and the pins are soldered to the base member 201. The base member 201 may be a printed circuit board (PCB), a bread board, an insulated metal substrate (IMS) board, etc. The base member 201 may be, and not limited to, a multi-layered PCB, a rigid PCB, flexible PCB, single layer PCB, aluminum backed PCB, etc. The electronic components 204 are mounted in a predetermined sequence on the base member 201 and accompanied by a heat dissipating assembly 212 of the electronic assembly 102. The heat dissipation assembly 212 is in thermal contact with the electronic components 204 to extract and dissipate the heat generated by the components 204. The longitudinal direction of the base member 201 is indicated by the arrow Y-Y' and the lateral direction of the base member 201 is indicated by the arrow X-X'. The electronic components 204 are positioned along the lateral direction and the longitudinal direction of the base member 201 in the predetermined sequence. The electronic components 204 are, for example, transistors, such as, BJTs, MOSFETs, capacitors, resistors, ICs, voltage converter board, etc. The components of the heat dissipation assembly 212 are spread in the lateral direction and the longitudinal direction of the base member 201 to remain in thermal contact with the electronic components 204.

The heat dissipation assembly 212 comprises cooling rails, such as, two cooling rails 202a, 202b, multiple transistor bridges, such as, 206 for cooling transistors, multiple capacitor bridges, such as, 207 for cooling capacitors, and at least one voltage converter bridge (not shown) positioned along the longitudinal direction of the base member 201. The cooling rails 202a, 202b are positioned proximal to the longitudinal sides of the base member 201 and extend in the longitudinal direction. The cooling rails 202a, 202b carry coolant along the longitudinal direction of the base member 201. The coolant in the cooling rails 202a, 202b flows through the transistor bridges 206, the capacitor bridges 207, and the voltage converter bridge (not shown) to extract heat from the transistors, the capacitors, and the voltage converter respectively and cool the components 204. The transistor bridges 206, the capacitor bridges 207, and the voltage converter bridge (not shown) extend between the cooling rails 202a, 202b in the lateral direction of the base member 201.

The cooling rail 202a comprises an inlet nozzle 203 removably engaging with an end and an end cap 209 removably engaging with the other end. Similarly, the cooling rail 202b comprises an outlet nozzle 210 removably engaging with an end and an end cap 211 with the other end. The inlet nozzle 203 and the outlet nozzle 210 are shown to be in longitudinally opposite directions. In an embodiment, the inlet nozzle 203 and the outlet nozzle 210 are in the same direction. The coolant flows into the cooling rail 202a through the inlet nozzle 203 and flows out of the cooling rail 202b through the outlet nozzle 210. The temperature of the coolant exiting from the outlet nozzle 210 is substantially higher than the temperature of the coolant entering through the inlet nozzle 203, due to the amount of heat carried away by the coolant while exiting through the outlet nozzle 210. In an embodiment, the coolant exiting from the outlet nozzle 210 may be cooled and re-circulated into the inlet nozzle 203 through an external recirculation line. The coolant may be water, ethylene glycol, etc.

In an embodiment, the sides of the base member 201 are slid into side mounting provisions of the cooling rails 202a, 202b for positioning the cooling rails 202a, 202b proximal to the longitudinal sides of the base member 201. In an embodiment, the cooling rails 202a, 202b have mounting provisions 205 on top to removably attach the cooling rails 202a, 202b to the base member 201 using attachment means, such as, fasteners. In an embodiment, each of the cooling rails 202a, 202b has a raised opening 208 at predetermined one or more locations for equalizing pressure of the coolant in the cooling rails 202a, 202b for facilitating smooth flow of the coolant from the cooling rail 202a towards the cooling rail 202b through the bridges 206, 207.

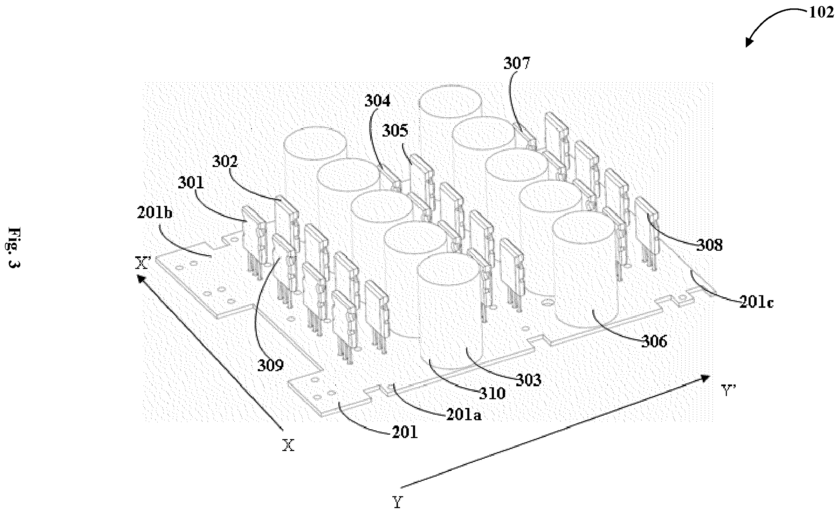

Fig. 3 exemplarily illustrates a perspective view of the electronic components positioned on the base member 201 of the electronic assembly 102. As exemplarily illustrated, multiple rows of transistors 301, 302, 304, 305, 307, 308, multiple rows of capacitors 303, 306, and at least one voltage converter board (not shown) are positioned in the longitudinal direction of the base member 201 and across a top surface 201b of the base member 201. Each row of transistors 301, 302, 304, 305, 307, 308 comprises multiple transistors, such as, 309 positioned consecutively in the lateral direction of the base member 201. Each of the rows of capacitors 303, 306 comprises multiple capacitors 310 positioned consecutively in the lateral direction of the base member 201. The voltage converter board (not shown) is positioned on the top surface 201b of the base member 201 proximal to an edge 201c of the base member 201. As per an embodiment, the transistors 309 have a flat external surface and the capacitors 310 have a cylindrical external surface. The shape of the base member 201 is configured to facilitate mounting of the cooling rails 202a, 202b to the sides of the base member 201 in the longitudinal direction as shown in Fig. 2. The base member 201 has mounting provisions, such as, holes 201a on the periphery for fastening the cooling rails 202a, 202b proximal to the sides of the base member 201.

As can be seen, the rows of capacitors 303, 306 are sequentially spaced from the rows of the transistors 301, 302, 304, 305, 307, 308. That is, a first row of capacitors 303 is positioned after two rows of transistors 301, 302. Similarly, a second row of capacitors 306 is positioned after two rows of transistors 304, 305. Further, another two rows of transistors 307, 308 are positioned on the base member 201, after the second row of capacitors 306. In the same fashion, multiple such rows of capacitors may be located after every two rows of the transistors on the base member to compactly design the electronic assembly based on the intended function of the electronic assembly. The electronic components on the base member are not limited to the capacitors, transistors, and the converter board. Based on the intended function of the electronic assembly, the base member may accommodate different electronic components in a similar fashion.

Consider, the electronic assembly 102 may be for a power board and the electronic product 100 is a controller of a 3-phase motor of a vehicle. The first row of transistors 301 may have low voltage transistors and the second row of transistors 302 may have high voltage transistors. Together, the rows of transistors 301, 302 correspond to a first phase of the three-phase voltage to drive the motor. Similarly, the third row of transistors 304 may have low voltage transistors and the fourth row of transistors 305 may have high voltage transistors. Together, the rows of transistors 304, 305 correspond to a second phase of the three-phase voltage. Similarly another set of low voltage transistors 307 and the high voltage transistors 308 correspond to a third phase of the three phase voltage. After the sets of transistor assembly for the first and the second phase, a row of capacitors 303, 306 is assembled, respectively. Since the phase transistors 301, 302, 304, 305, 307, 308 are arranged in rows back to back with capacitor banks 303, 306 between them, the overall packaging of the electronic assembly 102 is compact compared to designs with multiple PCBs to incorporate capacitors and the phase transistors separately.

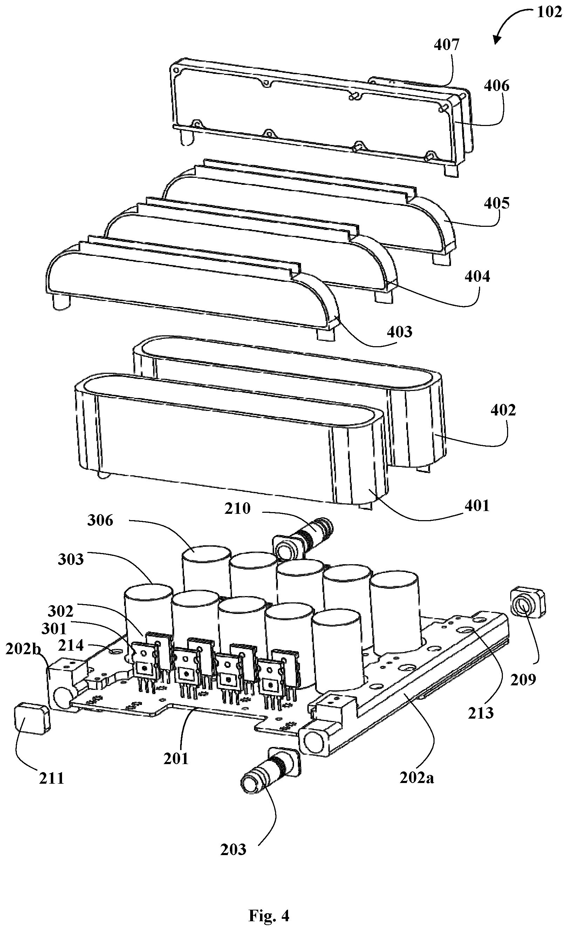

Fig. 4 exemplarily illustrates a partial exploded perspective view of the electronic assembly 102 shown in Fig. 2. The electronic assembly 102 comprises the base member 201 with the electronic components 301, 302, 303, 304, 305, 306, 307, 308, the transistor bridges 403, 404, 405, the capacitor bridges 401, 402, and the voltage converter bridge 406, and the cooling rails 202a, 202b. As exemplarily illustrated, the electronic assembly 102 comprises two capacitor bridges 401, 402 in thermal contact with the two rows of capacitors 303, 306, shown in Fig. 3, for dissipating the heat from the capacitors 310 in the two rows. Similarly, the electronic assembly 102 comprises three transistor bridges 403, 404, 405 in thermal contact with the three sets of rows of transistors 301, 302; 304, 305; 307, 308, shown in Fig. 3, for dissipating the heat from the transistors 309 in the six rows. Each transistor bridge is in thermal contact with the two rows of transistors. Also shown is the voltage converter board 407 that steps down a high voltage to a low voltage. The voltage converter board 407 may be aluminum backed PCB with ICs on its front side. The voltage converter bridge 406 is in thermal contact with the voltage converter board 407 for dissipating the heat from the voltage converter board 407. The front side of the voltage converter board 407 is in thermal contact with the voltage converter bridge 406.

The two capacitor bridges 401, 402, the transistor bridges 403, 404, 405, and the voltage converter bridge 406 extend from the cooling rail 202a to the cooling rail 202b in the lateral direction of the base member 201. The number of bridges 401, 402, 406, corresponds to the number of rows of capacitors 310 and the number of voltage converter boards 407on the base member 201. The construction of the bridges 401, 402, 403, 404, 405, 406 varies based on the external surface of the electronic components 301, 302, 303, 304, 305, 306, 307, 308, 407. The bridges 401, 402, 403, 404, 405, 406 are in physical contact with the external surface of the electronic components 301, 302, 303, 304, 305, 306, 307, 308, 407 for extracting the heat dissipated by the components 301, 302, 303, 304, 305, 306, 307, 308, 407. The coolant flows through the internal parts of the bridges 401, 402, 403, 404, 405, 406 as will be explained further and extracts the heat from the external surface of the electronic components 301, 302, 303, 304, 305, 306, 307, 308, 407. As can be seen, the cooling rails 202a, 202b comprise openings 213, 214 corresponding to inlet ports and outlet ports of the bridges 401, 402, 403, 404, 405, 406. The coolant in the cooling rail 202a enters into the inlet ports of the bridges 401, 402, 403, 404, 405, 406 through the openings 213 and exits into the cooling rail 202b from the outlet ports of the bridges 401, 402, 403, 404, 405, 406 into the openings 214, after extracting heat from the electronic components 301, 302, 303, 304, 305, 306, 307, 308, 407.

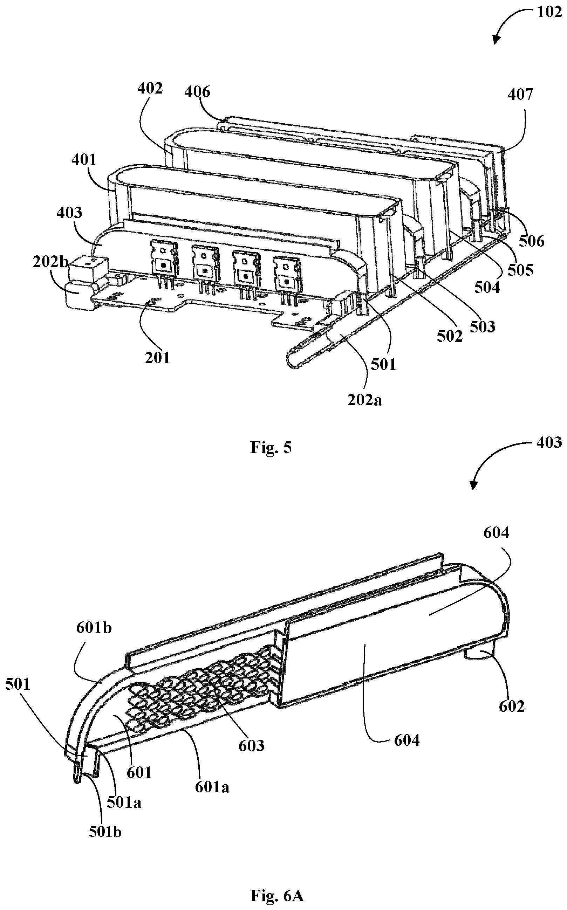

Fig. 5 exemplarily a sectional perspective view of the electronic assembly 102 illustrated in Fig. 4. As exemplarily illustrated, the transistor bridge 403 is positioned between the first row of transistors 301 and the second row of transistors 302. Similarly, the transistor bridge 404 is positioned between the third row of transistors 304 and the fourth row of transistors 305 and the transistor bridge 405 is positioned between the fifth row of transistors 307 and the sixth row of transistors 308. The first row of capacitors 303 and the second row of capacitors 306 are enclosed in a housing of the capacitor bridges 401, 402 respectively. The voltage converter board 407 is screwably attached to the voltage converter bridge 406 and the components on the front side of the voltage converter board 407 are in thermal contact with the voltage converter bridge 406.

The cooling rails 202a, 202b are tubular structures, to carry the coolant, with a circular or rectangular cross section. The inlet port 501, 502, 503, 504, 505, 506 of each of the bridges 401, 402, 403, 404, 405, 406 is a tubular structure that engages in the openings, such as, 213 in the cooling rail 202a. The inlet port 501, 502, 503, 504, 505, 506 extends for substantially the height of the bridges 401, 402, 403, 404, 405, 406, respectively. The outlet ports (not shown) of the bridges 401, 402, 403, 404, 405, 406 have a construction similar to that of the inlet ports 501, 502, 503, 504, 505, 506. The coolant rises in the inlet ports 501, 502, 503, 504, 505, 506 of the bridges 401, 402, 403, 404, 405, 406 due to the capillary action of the coolant. The coolant falls through the outlet port of the bridges 401, 402, 403, 404, 405, 406 due to gravity into the openings 214 of the cooling rail 202b. The construction features of the individual bridges 401, 402, 403, 404, 405, 406 are described further.

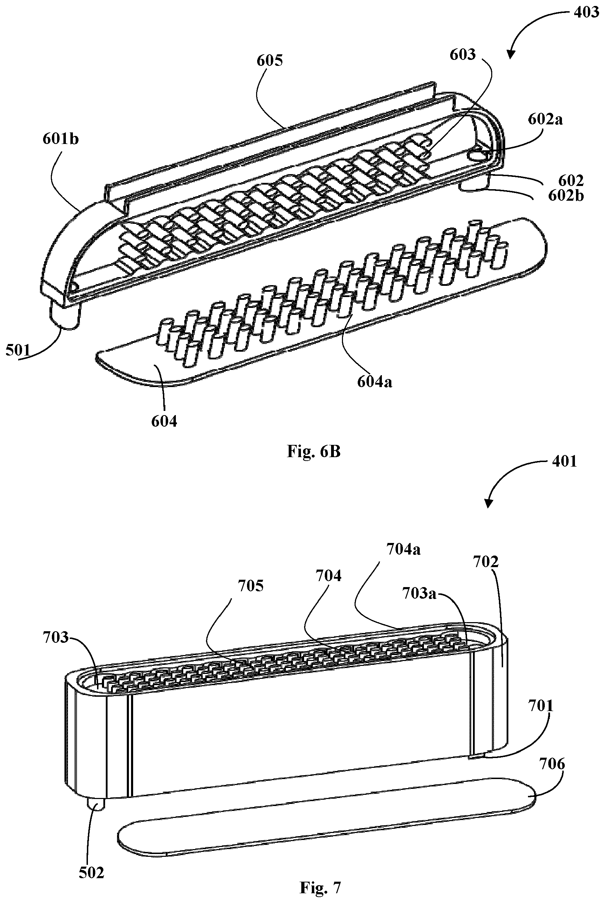

Figs. 6A-6B exemplarily illustrate the transistor bridge 403 of the electronic assembly 102. Fig. 6A exemplarily illustrates a partial section perspective view of the transistor bridge 403 and Fig. 6B exemplarily illustrates an exploded perspective view of the transistor bridge 403. The transistor bridge 403 comprises the inlet port 501, the outlet port 602, and a depression 601. The inlet port 501 comprises a first end 501a and a second end 501b. The second end 501b removably engages with the opening 213 in the cooling rail 202a for the coolant to flow in. Similarly, the outlet port 602 comprises a first end 602a and a second end 602b. The second end 602b removably engages with the opening 214 in the cooling rail 202b for the coolant to flow out after extracting heat from the transistors 309 in two rows 301, 302 that are in thermal contact with the transistor bridge 403. The transistor bridge 403 stands erect on the cooling rails 202a, 202b. The depression 601 extends between the first end 501a of the inlet port 501 and the first end 602a of the outlet port 602. The depression 601 is a cavity with a depth substantially equal to the thickness of the transistor bridge 403 in the longitudinal direction of the base member 201. The depression 601 is filled with the coolant from the first end 501a of the inlet port 501 to the first end 602a of the outlet port 602. The depression 601 holds some volume of coolant for a predetermined time to extract heat from both sides of external surface 601b of the depression 601 which is in thermal contact with the external surface of the transistors 309. A cover 604 is removably attached to the peripheral walls 601a of the depression 601 for sealing the depression 601 and holding the coolant within. The coolant flows in a lateral direction of the bridge 403 from the inlet port 501 to the outlet port 602.

In an embodiment, the transistor bridge 403 comprises multiple heat transfer members 603 in the depression 601 and extending from the bottom surface of the depression 601 along the length of the peripheral walls 601a of the depression 601, for heat transfer from the first row of transistors 301 with the coolant in the depression 601. Further, in an embodiment, the cover 604 comprises multiple extenders 604a disposed on an inner surface for removably engaging with the heat transfer members 603 disposed in the depression 601. In an embodiment, the extenders 604a are heat transfer members that transfer heat from the second row of transistors 302 to the coolant in the depression 601. The transistor bridge 403 comprises a flat first external surface 601b on both sides for establishing thermal contact with the rows of transistors 301, 302 using an attachment means, such as thermal pads, adhesives, fasteners, Velcro fasteners, etc. In an embodiment, the transistor bridge 403 comprises a plurality of heat dissipating structures 605, such as, fins on a second external surface for dissipating the extracted heat from the coolant in the depression 601 to the surroundings.

Fig. 7 exemplarily illustrates a partial exploded perspective view of the capacitor bridge 401 of the electronic assembly 102. The capacitor bridge 401 comprises the inlet port 502, an outlet port 701, and a housing 702. The inlet port 502 comprises a first end (not shown) and a second end (not shown). The second end removably engages with the opening 213 in the cooling rail 202a for the coolant to flow in. Similarly, the outlet port 602 comprises a first end (not shown) and a second end (not shown). The second end removably engages with the opening 214 in the cooling rail 202b for the coolant to flow out after extracting heat from a row of capacitors 303. The capacitor bridge 401 stands erect on the cooling rails 202a, 202b. The housing 702 encloses the row of capacitors 303 positioned in a row on the base member 201.

The housing 702 comprises a bottom portion (not shown) and a top portion 703. The bottom portion substantially encloses the inlet port 502, the outlet port 701, and the capacitors 303. The top portion 703 extends from a top wall 703a of the bottom portion forming a depression 704. The depression 704 extends between the first end of the inlet port 502 and the first end of the outlet port 701. The depression 704 is a cavity with a predetermined vertical depth. The depression 704 is filled with the coolant from the first end of the inlet port 502 to the first end of the outlet port 701. The depression 704 holds some volume of coolant for a predetermined time to extract heat from the internal surface of the bottom portion of the housing 702 that is in thermal contact with the external surface of the capacitors 303. A cover 706 is removably attached to the peripheral walls 704a of the depression 704 for sealing the depression and holding the coolant within. The coolant flows in a horizontal direction of the bridge 401 from the inlet port 502 to the outlet port 701.

In an embodiment, the capacitor bridge 401 comprises multiple heat transfer members 705 disposed in the depression 704 and extending from the top wall 703a of the bottom portion along the length of the peripheral walls 704a of the depression 704, for heat transfer from the capacitors 303 to the coolant in the depression 704. In an embodiment, the contour of the top wall 703 of the bottom portion of the housing 701 matches with external surface of the capacitors 303 enclosed by the bottom portion of the housing 701 for establishing thermal contact using an attachment means, such as, adhesives, thermal conductive gels, thermal pads, fasteners, Velcro fasteners, etc.

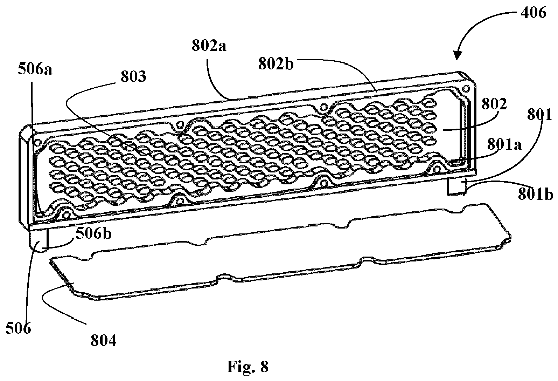

Fig. 8 exemplarily illustrates a partial exploded perspective view of the voltage converter bridge 406 of the electronic assembly 201. The voltage converter bridge 406 comprises the inlet port 506, the outlet port 801, and a depression 802. The inlet port 506 comprises a first end 506a and a second end 506b. The second end 506b removably engages with the opening 213 in the cooling rail 202a for the coolant to flow in. Similarly, the outlet port 801 comprises a first end 801a and a second end 801b. The second end 801b removably engages with the opening 214 in the cooling rail 202b for the coolant to flow out after extracting heat from the voltage converter board 407 that is in thermal contact with the voltage converter bridge 406. The voltage converter bridge 406 stands erect on the cooling rails 202a, 202b. The depression 802 extends between the first end 506a of the inlet port 506 and the first end 801a of the outlet port 801. The depression 802 is a cavity with a depth substantially equal to the thickness of the voltage converter bridge 406 in the longitudinal direction of the base member 201. The depression 802 is filled with the coolant from the first end 506a of the inlet port 506 to the first end 801a of the outlet port 801. The depression 802 holds some volume of coolant for a predetermined time to extract heat from one side of the external surface of the depression 802 in thermal contact with the external surface 802a of the voltage converter board 407. A cover 804 is removably attached to the peripheral walls 802b of the depression 802 for sealing the depression 802 and holding the coolant within. The coolant flows in a lateral direction of the voltage converter bridge 406 from the inlet port 506 to the outlet port 801.

In an embodiment, the voltage converter bridge 406 comprises multiple heat transfer members 803 disposed in the depression 802 and extending from the bottom surface of the depression 802 along the length of the peripheral walls 802b of the depression 802, for heat transfer from the voltage converter board 407 to the coolant in the depression 802. The voltage converter bridge 406 comprises a flat first external surface 802a on one side for establishing thermal contact with the plurality of voltage converter board 407 using an attachment means, such as, adhesives, thermal conductive gels, thermal pads, fasteners, Velcro fasteners, etc.

The electronic assembly with the heat dissipation assembly in the electronic product as disclosed in the present invention provides the following technical advancement in the field of design of electronic products: During normal operation of the electronic products, the temperature of electronic components within rises. During charging, overcharging, and extended operation, the temperatures may drastically rise. In both these conditions, the heat dissipation assembly and its associated components, such as the coolant, the cooling rails, the bridges, extract and dissipate the heat away from the electronic components. The bridges reduce the temperature of the individual electronic components, such as, transistors, capacitors, etc., and subsequently cool the electronic assembly and the electronic product actively and efficiently.

The profile of the external surface of the transistor bridges and the voltage converter bridges conforms to the profile of the external surface of the transistors and the voltage converter board respectively, thereby achieving large area of thermal contact. In the case of the capacitor bridges, the profile of internal surface of the housing ensures large contact area with the external surface of the capacitors to effectively extract heat from the capacitors. Also, the assembly of the bridges along with the electronic components ensures a compact packaging of the electronic assembly and the electronic product. Implementing the transistor bridges with two sides flat allows to save the number of bridges for each individual row of transistors, saving space, time, and money in the assembly, maintenance, and replacement.

Since the inlet ports and the outlet ports are connected to same set of cooling rails, compact packaging of the heat dissipation assembly and the electronic assembly is feasible. Since the cooling bridges are parallel, the flow through the bridges is balanced. In an embodiment, the flow rates to individual bridges can be varied based on the temperatures of the electronic components being cooled. To maintain continuous flow of the coolant, the pressure in both the cooling rails is equalized using openings in the cooling rails. The design of the electronic assembly with the heat dissipation assembly ensures cooling of all the major thermal contributors in the electronic assembly. The assembly of the electronic components on the base member and the assembly of the components of the heat dissipation assembly are not cumbersome and are guided by the features of the components, such as, the inlet port, the outlet port, the end caps, the nozzles, etc. With a common bridge cooling multiple electronic components, the crowding of the components and their respective heat sinks is avoided, thereby reducing weight of the electronic assembly, number of parts to be assembled, cost of the electronic assembly, and their associated costs. Due to the compact packaging of the electronic assembly, the dimensions of the electronic product are also reduced, making space for other additional features in a space crunched vehicle. The components of the electronic assembly are modular and can be added to the existing circuit design of the existing electronic product with ease, to achieve prolonged operation of the electronic product, higher efficiency throughout its operation, and avoiding occurrences of any kind of catastrophes in the space crunched applications. The heat dissipation assembly can also function along with existing cooling mechanism of the electronic product. The sealing of the coolant in the bridges is also taken care by the use of the covers on the bridges and the end caps in the cooling rails, to prevent the leakage of the coolant.

The attachment means to establish thermal contact between the components and the surfaces of the bridges facilitate effective heat transfer with the coolant in the bridges. The components of the electronic assembly are light weight, have features that guide in mounting while assembly, maintenance, and servicing, are thin not occupying more space, making the electronic product compact, as well as safe to use, preventing thermal runaway and elevated operating temperatures. The electronic product with such an electronic assembly has wattage in the range of about 0-50 kW and finds application in space constrained mobile devices, products, vehicle, such, two-wheelers, three-wheelers, or any multi-wheeled vehicle, such passenger trucks that experience lot of shock and vibrations. The components of the electronic assembly are tightly lodged into the base member and the cooling rails and tightly adhered to the electronic components and do not get dislodged due to vibration and shocks.

In the electronic assembly for a controller for the 3-phase motor exemplarily disclosed in the detailed description, implementing both low and high side of phase transistor set and keeping smaller track between the both, results in lesser losses. Further, since the capacitor banks are in between the transistors, this manner of assembling them results in optimal track distance from the transistors to the capacitors, reducing the electrical losses between them.

Improvements and modifications may be incorporated herein without deviating from the scope of the invention.

### LIST OF REFERENCE NUMERALS

100 - Electronic product
101 - Casing
102 - Electronic assembly
103 - First end cover
104 - Second end cover
201 - Base member
201a - holes proximal to sides of the base member
201b - top surface of base member
201c - edge of the base member
202a, 202b - cooling rails
203 - inlet nozzle
204 - Electronic components
205 - mounting provisions on cooling rails
206 - Transistor bridges
207 - Capacitor bridges
208 - raised opening in cooling rails
209 - End cap in cooling 202a
210 - outlet nozzle
211 - end cap in cooling rail 202b
212 - Heat dissipation assembly
213, 214 - openings in cooling rails
301 - First row of transistors
302 - Second row of transistors
303 - First row of capacitors
304 - Third row of transistors
305 - Fourth row of transistors
306 - Second row of capacitors
307 - Fifth row of transistors
308 - Sixth row of transistors
309 - Transistors
310 - Capacitors
401,402 - capacitor bridges
403, 404, 405 - transistor bridges
406 - Voltage converter bridge
407 - Voltage converter board
501 - Inlet port of transistor bridge 403
501a - first end of the inlet port of transistor bridge 403
501b - second end of the inlet port of transistor bridge 403
502 - Inlet port of capacitor bridge 401
502a - first end of the inlet port of capacitor bridge 401
502b - second end of the inlet port of capacitor bridge 401
503 - inlet port of transistor bridge 404
504 - Inlet port of capacitor bridge 402
505 - inlet port of transistor bridge 405
506 - Inlet port of voltage converter bridge 406
506a - first end of the inlet port of voltage converter bridge 406
506b - second end of the inlet port of voltage converter bridge 406
601 - depression of the transistor bridge 403
601a - peripheral walls
601b - flat first external surface of transistor bridge 403
602 - outlet port of the transistor bridge 403
602a - first end of the outlet port of transistor bridge 403
602b - second end of the outlet port of transistor bridge 403
603 - Heat transfer members
604 - Cover
604a - extenders
605 - Heat dissipating structures
701 - Outlet port of the capacitor bridge 401
701a - first end of the outlet port of capacitor bridge 401
701b - second end of the outlet port of capacitor bridge 401
702 - housing
703 - top portion
703a - top wall
704 - depression
704a - peripheral walls
705 - Heat transfer members
706 - cover
801 - Outlet port of the voltage converter bridge 406
701a - first end of the outlet port of voltage converter bridge 406
701b - second end of the outlet port of voltage converter bridge 406
802 - depression
802a - external surface
803 - Heat transfer members
804 - cover

## Claims

1. An electronic assembly (102) of an electronic product (100) comprising:
a base member (201);
a plurality of electronic components (204) removably positioned in a predetermined sequence on the base member (201); and
a heat dissipation assembly (212) positioned in thermal contact with each of the plurality of electronic components (204) on the base member (201).

2. The electronic assembly (102) of claim 1, wherein the plurality of electronic components (204) comprises:
a plurality of rows of transistors (301, 302, 304, 305, 307, 308) positioned across a top surface (201b) of the base member (201) longitudinally, wherein each of the plurality of rows of transistors (301, 302, 304, 305, 307, 308) comprises a plurality of transistors (309) positioned consecutively in a lateral direction (X-X') of the base member (201),
a plurality of rows of capacitors (303, 306) sequentially spaced from the plurality of rows of transistors (301, 302, 304, 305, 307, 308) on the top surface (201b) of the base member (201), wherein each of the plurality of rows of capacitors (303, 306) comprises a plurality of capacitors (310) positioned consecutively in the lateral direction (X-X') of the base member (201), and
at least one voltage converter board (407) positioned on the top surface (201b) of the base member (201) proximal to an edge (201c) of the base member (201).

3. The electronic assembly (102) of claim 1 or 2, wherein the heat dissipation assembly (212) comprises
a plurality of cooling rails (202a, 202b) positioned proximal to sides of the base member (201) and extending longitudinally for facilitating flow of coolant longitudinally across the base member (201),
a plurality of transistor bridges (403, 404, 405) extending between the plurality of cooling rails (202a, 202b) and in thermal contact with the plurality of rows of transistors (301, 302, 304, 305, 307, 308) for dissipating the heat from the plurality of rows of transistors (301, 302, 304, 305, 307, 308),
a plurality of capacitor bridges (401, 402) extending between the plurality of cooling rails (202a, 202b) and in thermal contact with the plurality of rows of capacitors (303, 306) for dissipating the heat from the plurality of rows of capacitors (303, 306), and
at least one voltage converter bridge (406) extending between the plurality of cooling rails (202a, 202b) and in thermal contact with the at least one voltage converter board (407) for dissipating the heat from the at least one voltage converter board (407).

4. The electronic assembly (102) of claim 3, wherein the plurality of cooling rails (202a, 202b) comprise:
an inlet nozzle (203) removably engaging with one end of one of the plurality of cooling rails (202a) for the coolant to flow into the plurality of cooling rails (202a, 202b) to extract heat from the plurality of rows of transistors (301, 302, 304, 305, 307, 308), the plurality of rows of capacitors (303, 306), and the at least one voltage converter board (407), and
an outlet nozzle (210) removably engaging with one end of another of the plurality of cooling rails (202b) for the coolant to flow out after extracting heat from the plurality of rows of transistors (301, 302, 304, 305, 307, 308), the plurality of rows of capacitors (303, 306), and the at least one voltage converter board (407), using the plurality of transistor bridges (403, 404, 405), the plurality of capacitor bridges (401, 402), and the at least one voltage converter bridge (406).

5. The electronic assembly (102) of claim 3 or 4, wherein each of the plurality of transistor bridges (403, 404, 405) comprises:
an inlet port (501) removably connected to one of the plurality of cooling rails (202a) for the coolant to flow in,
an outlet port (602) removably connected to another of the plurality of cooling rails (202b) for the coolant to flow out after extracting heat from the plurality of transistors (309),
a depression (601) extending between a first end (501a) of the inlet port (501) and a first end (602a) of the outlet port (602) configured to be filled with the coolant for extracting heat from the plurality of transistors (309), and
a cover (604) removably attached to peripheral walls (601a) of the depression (601) for closing the depression (601).

6. The electronic assembly (102) of claim 5, wherein the cover of each of the plurality of transistor bridges (403, 404, 405) comprises a plurality of extenders (604) disposed on an inner surface (604a) for removably engaging with a plurality of heat transfer members (603) disposed in the depression (601).

7. The electronic assembly (102) of any one of claims 3 to 6, wherein each of the plurality of transistor bridges (403, 404, 405) further comprises a plurality of heat transfer members (603) disposed in the depression (601) and extending from the bottom surface of the depression (601) along the length of the peripheral walls (601a) of the depression (601), for heat transfer from each of the plurality of transistors (309) with the coolant in the depression (601).

8. The electronic assembly (102) of any one of claims 3 to 7, wherein the each of the plurality of transistor bridges (403, 404, 405) comprises a flat first external surface (601b) on both sides for establishing thermal contact with the plurality of transistors (309) using an attachment means and a plurality of heat dissipating structures (605) on a second external surface for dissipating the extracted heat from the coolant in the depression (601) to the surroundings.

9. The electronic assembly (102) of any one of claims 3 to 8, wherein the each of the plurality of transistor bridges (403, 404, 405) stand erect on the plurality of cooling rails (202a, 202b) using a second end (501b) of the inlet port removably engaging with an opening (213) in the one of the plurality of cooling rails (202a) and a second end (602b) of the outlet port (602) removably engaging with an opening (214) in the another of the plurality of cooling rails (202b).

10. The electronic assembly (102) of any one of claims 5 to 9, wherein the coolant vertically rises in the inlet port (501) through a second end (501b) of the inlet port (501), flows in the depression (601) in the lateral direction (X-X') of the each of the plurality of transistor bridges (403, 404, 405), and exits through a second end (602b) of the outlet port (602).

11. The electronic assembly (102) of any one of claims 3 to 10, wherein each of the plurality of capacitor bridges (401, 402) comprises:
an inlet port (502) removably connected to the one of the plurality of cooling rails (202a) for the coolant to flow in,
an outlet port (701) removably connected to the another of the plurality of cooling rails (202b) for the coolant to flow out after extracting heat from the plurality of capacitors (310), and
a housing (702) enclosing the plurality of capacitors (310) positioned on the base member (201).

12. The electronic assembly (102) of claim 11,
wherein the housing comprises:
a bottom portion substantially enclosing the inlet port (502), the outlet port (701), and the plurality of capacitors (310),
a top portion (703) extending from a top wall (703a) of the bottom portion forming a depression (704) extending between a first end (502a) of the inlet port (502) and a first end (701a) of the outlet port (701) for the coolant to flow and extract heat from the plurality of capacitors (310), and
a cover (706) removably attached to peripheral walls (704a) of the depression (704) for closing the depression (704),
wherein the each of the plurality of capacitor bridges (401, 402) further comprises a plurality of heat transfer members (705) disposed in the depression (704) and extending from the top wall (703a) of the bottom portion along the length of the peripheral walls (704a) of the depression (704), for heat transfer from each of the plurality of capacitors (310) with the coolant in the depression (704),
wherein contour of the top wall (703a) of the bottom portion of the housing (702) conforms with an external surface of the plurality of capacitors (310) enclosed by the bottom portion of the housing (702), for establishing thermal contact using an attachment means,
wherein the coolant vertically rises in the inlet port (502) through a second end (502b) of the inlet port (502), flows in the depression (704) in a horizontal direction of the each of the plurality of capacitor bridges (401, 402), and exits through a second end (701b) of the outlet port (701).

13. The electronic assembly (102) of claim 11, wherein the each of the plurality of capacitor bridges (401, 402) stand erect on the plurality of cooling rails (202a, 202b) using a second end (502b) of the inlet port (502) removably engaging with an opening (213) in the one of the plurality of cooling rails (202a) and a second end (701b) of the outlet port (701) removably engaging with an opening (214) in the another of the plurality of cooling rails (202b).

14. The electronic assembly (102) of any one of claims 3 to 13, wherein the at least one voltage converter bridge (406) comprises:
an inlet port (506) removably connected to the one of the plurality of cooling rails (202a) for the coolant to flow in,
an outlet port (801) removably connected to the another of the plurality of cooling rails (202b) for the coolant to flow out after extracting heat from the at least one voltage converter board (407),
a depression (802) extending between a first end (506a) of the inlet port (506) and a first end (801a) of the outlet port (801) configured to be filled with the coolant for extracting heat from the at least one voltage converter board (407), and
a cover (804) removably attached to peripheral walls (802b) of the depression (802) for closing the depression (802).

15. The electronic assembly (102) of claim 14,
wherein the at least one voltage converter bridge (406) further comprises a plurality of heat transfer members (803) disposed in the depression (802) and extending from the bottom surface of the depression (802) along the length of the peripheral walls (802b) of the depression (802), for heat transfer from each of the plurality of transistors (309) with the coolant in the depression (802),
wherein the cover (804) of at least one voltage converter bridge (406) comprises a plurality of extenders disposed on an inner surface for removably engaging with a plurality of heat transfer members (803) disposed in the depression (802),
wherein the at least one voltage converter bridge (406) comprises a flat first external surface (802a) on one side for establishing thermal contact with the at least one voltage converter board (407) using an attachment means,
wherein the at least one voltage converter bridge (406) stands erect on the plurality of cooling rails (202a, 202b) using a second end (506b) of the inlet port (506) removably engaging with an opening (213) in the one of the plurality of cooling rails (202a) and a second end (801b) of the outlet port (801) removably engaging with an opening (214) in the another of the plurality of cooling rails (202b),
wherein the coolant vertically rises in the inlet port (506) through a second end (506b) of the inlet port (506), flows in the depression in a lateral direction of the at least one voltage converter bridge (406), and exits through a second end (801b) of the outlet port (801b),
